# EUROPEAN PATENT SPECIFICATION

(11) **EP 2 833 154 B1**
(45) Date of publication and mention of the grant of the patent: **06.04.2022**
(21) Application number: 13003868.0
(22) Date of filing: 02.08.2013
(51) Int. Cl.: G01R 15/04

(54) **Voltage sensor device**
Spannungssensorvorrichtung
Dispositif de détection de tension

(43) Date of publication of application: 04.02.2015
(73) Proprietor: ABB Schweiz AG, 5400 Baden (CH)
(72) Inventor: Podzemny, Jaromir, 621 00 Brno (CZ); Pavlas, Marek, 68354 Otnice (CZ); Hrabcik, Miroslav, 798 27 Nemcice nad Hanou (CZ); Javora, Radek, 664 62 Hrusovany u Brna (CZ)
(74) Representative: Maiwald Patent- und Rechtsanwaltsgesellschaft mbH

(56) References cited:
- EP-A1- 2 605 023
- WO-A1-99/14604
- DE-A1- 10 024 335
- DE-C- 606 438
- US-A- 1 047 742
- US-A1- 2006 012 382

## Description

The invention relates to a voltage sensor device, with at least one high voltage segment, and at least one low voltage impedance element.

Known voltage divider for voltage sensor devices have sensing elements based on voltage divider, which generally consist of the high voltage impedance, e.g. a resistor part and a low voltage impedance part. According to the required application parameters, that means voltage and ratio, the sensing element can be bulky and thus not fitting the insulating sensor body available.

EP2605023A1 relates to a resistive voltage divider comprising a plurality n of resistive elements in a configuration wherein the angles m=n-1 between each pair of elements are between 180° and 10°. The group of elements is supported by a dielectric the shape of which is such that it allows the creepage distance of the divider to be equal to or longer than the sum of creepage distances of the individual resistances. This arrangement allows a correct insulation of the device because it maintains the outer insulation since in the event of short-circuit the current will flow through the resistances and not through the support.

Furthermore heat dissipated from used impedance elements during operation are flowing upwards, heating up other parts of impedance elements that may limit parameters under which the divider is operating. This is a great disadvantage.

So it is the object of the invention, to enhance the power dissipation due to impedances spread inside of the device body.

The invention is defined in appended claim 1.

So the invention is, the sensing element is adaptive and/or extendable in that way, that at least one high voltage segment, and at least one low voltage impedance element are arranged on an elongated insulating support (30) with adaptive complementary mechanical and electrical interconnection elements (71-79) at least one end of the support element, in order to interconnect at least two such support elements together in a pivotable way.

According to the invention, the sensor device can be dimensionally adapted by the aforesaid adaptive mechanical and electrical interconnection system and/or pivoted by an angle among the segments or supports.

The segmentation and placement of impedance elements allow a relative position under an angle which is smaller that 180°C.

The resulting value of impedance of the impedance elements can be built up together from standard impedance elements values.

According to the invention, the impedance elements are either capacitive elements or a combination of resistive elements and capacitive elements.

According to the invention, the impedance elements are connected within given segment in parallel and/or in series, providing required impedance value.

Furthermore, the elements are assembled into at least partly fixed configuration with at least partly given dimensions and at least partly fixed angle between elements, having main fixed insulating support consisting of several elements and/or further possible connection to other separate elements.

A last advantageous embodiment is, that the fixed insulating support has a possibility to mechanically reduce the number of elements by breaking or cutting off the unused part of said support.

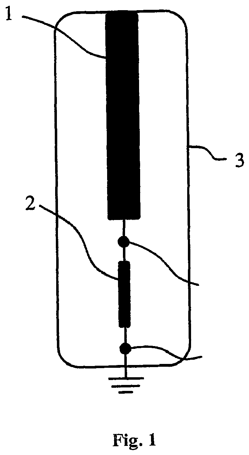

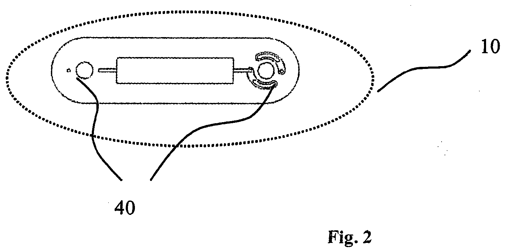

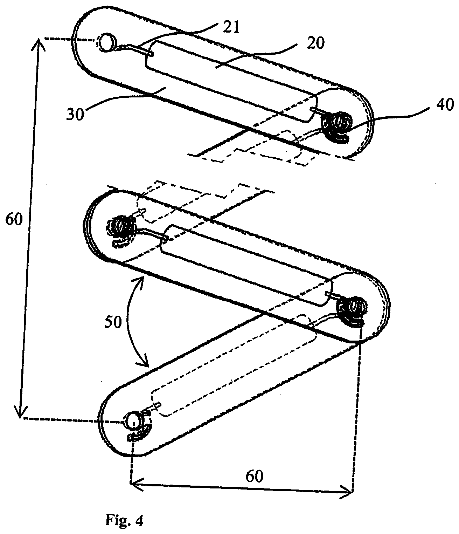

An embodiment of the invention is shown in Figures 1 to 6 .

This invention describes adaptive voltage sensing element assembled from segments 10. The said voltage sensing element generally consists of high voltage part and low voltage part, corresponding to Fig. 1. The high voltage part consists of at least one segment 10. Such segment is further called high voltage segment. The low voltage part can be placed on a separate segment (further called low voltage segment) or it can be located on one of the high voltage segments. The segment 10 itself consists of at least one impedance element 20, an insulated support 30 and connection system 40. Said connection system serves for mechanical purpose and for conductive segments interconnection.

Said connection system allows to:
change angle 50 between the segments 10,
change position of the resistive elements

Above mentioned construction allows adaptation of dimensions 60 of voltage sensing element.

The impedance 20 can be placed on one side, both sides or alternately on one and the other side of the insulation support 30. Except of space benefit the said device has following advantages:
better power dissipation due to impedances spread inside of the device body 3,
better power dissipation due to impedances placement on both sides of the insulating support 30, longer creepage distance of the functional parts,
resulting value of impedance can assembled from standard values (rows) thus decrease final costs.

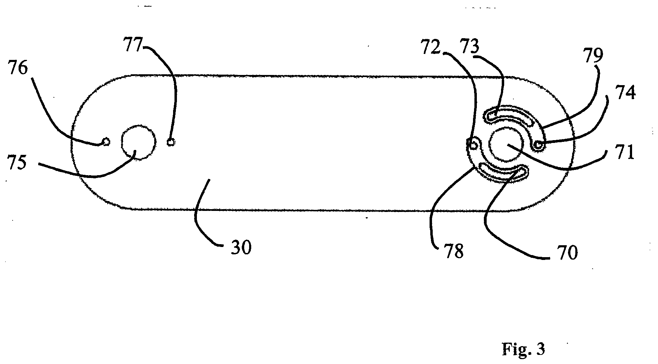

Insulating support 30 is shown in Fig. 3 . Its connection system 40 consists of special connection features provided on insulating support 30. Such connection system 40 has basically two ends. At both ends of insulating support 30, the connection system has a hole 75 and 71, through which the segments are fixed to each other. Fixation could be made by rivet or screw, which passes through the hole 75 of one segment and hole 71 of another segment, or by other connection means. By tightening two segments e.g. by the screw, one can fix the angle 50 between mentioned segments 10 and thus set required height and width 60 of the final assembly. In order to achieve better power dissipation from impedance elements 20, it is preferable that impedance elements 20 are located under set angle 50 which is smaller then 180°. This arrangement will also result in longer creepage distance of the functional parts comparing to the standard solution used in Fig. 1, which can give bigger dielectric behavior.

Insulating support 30 has in addition two small holes 76 and 77. The output wire 21 from impedance element 20 passes through one of these holes, depending on size and configuration of selected impedance element 20. On the other side of insulating support 30 there are two conductive elements 78 and 79. Each of them has one hole 72 and 74 respectively, size-wise corresponding to the holes 76 and 77 on the other side, and one oval opening 70 and 73 respectively. These holes and openings serves for electrical interconnection 4 of impedance elements 20 on different segments. In case hole 72 is used for soldering of one end of impedance element on the conductive element 78 of the insulating support 30, one end of impedance element from the other segment has to be connected to the same conductive element 78, but soldered through the oval opening 70 in order to provide necessary electrical interconnection. Oval opening 70 allows soldering of resistive element 20 in a place that is the most suitable for set angle 50.

In case longer impedance element 20 has to be used, conductive element 79 could be used instead of conductive element 78 and/or hole 76 could be used instead of hole 77 on the other side of insulating support 30.

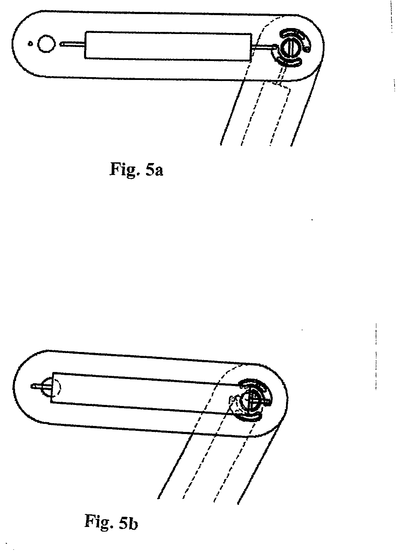

In addition, the connection system 40 allows to place impedance
a) with a gap, as shown in Fig. 5a ;
b) crossed, like shown in Fig. 5b .

Connection with gap can be used in case the impedance elements are not too long. In such a case all impedances could be placed on the same side of all segments as there is no space constraint. Alternating sides placement could be applied as well, in order to get e.g. better power dissipation from impedance elements used.

In case of long impedance, crossed connection according to Fig. 5b can be preferably used. For this configuration, alternating side placement might be the only possible placement of impedance elements 20 in order to have the smallest width of final assembly.

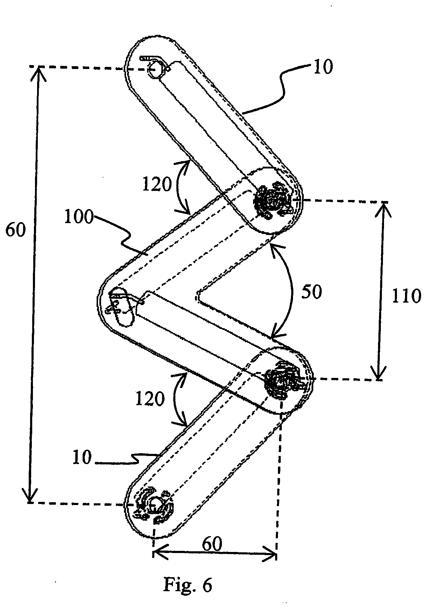

It is also possible to have fixed or partly fixed, like shown in Fig. 6 configuration of such elements for a given application.
a) Partly fixed configuration is characterized in that it consists of fixed element 100 which contains at least one impedance element 20, and at least one flexible segment 10. Dimensions 60 and angle 120 are still adaptable, but the angle 50 on fixed element is fixed.
b) Fixed configuration contains only fixed element 110 with at least one impedance element 20. Dimensions 60 and angle 50 are fixed. In that case the insulating support 30 consists of several segment supports;

Fig. 6 shows only example of two segments forming fixed configuration, but there could be also 3 segments in "Z" configuration, etc., with possibility to have more and more branches of the final configuration) forming a single body/support which does not need and does not have the possibility to be adjusted. Such fixed support, if produced as standard part, can be further height reduced by breaking or cutting off the unused part of said support.

In order to reach required value if impedances required for voltage divider, impedance elements could be assembled to the segments 10 and these segments connected in series, thus increasing total impedance of the divider. In order to decrease production costs or to improve power withstand, it can be advantageous to use standard, and thus cheaper, impedance elements which are connected within given segment in parallel and/or in series, providing required impedance value.

### Position numbers

- 1: High voltage impedance
- 2: Low voltage impedance
- 3: Insulating sensor body
- 10: Segment
- 20: impedance element
- 21: connector
- 30: insulating support
- 40: connection system
- 50: change angle
- 60: dimensions
- 71: hole
- 72: hole
- 73: oval opening
- 74: hole
- 75: hole
- 76: hole
- 77: hole
- 78: conductive element
- 79: conductive element
- 100: fixed element
- 110: fixed element
- 120: angle

## Claims

1. A voltage sensor device, with a high voltage part (1), and a low voltage part (2), the voltage sensor device comprising:
- a plurality of segments (10); and
- a plurality of impedance elements (20);
wherein the high voltage part is formed from at least one segment and the low voltage part is formed from at least one segment;
wherein, each segment comprises at least one impedance element, an insulated support (30) and a connection system (40);
wherein, the connection system for each segment has a first part at a first end of each segment and a second part at a second end of each segment;
wherein, the connection system is configured to mechanically connect adjacent pairs of segments to each other and the connection system is configured to electrically connect the at least one impedance element of adjacent pairs of segments to each other, wherein a first part of the connection system of one segment of adjacent pairs of segments is configured to connect to a second part of the connection system of a second segment of adjacent pairs of segments;
wherein, the connection system is configured to enable the angle between adjacent pairs of segments to be changed; **characterised in that** the impedance elements are either capacitive elements or a combination of resistive elements and capacitive elements; and the impedance elements are connected within at least one segment in parallel and the impedance elements are connected within at least one other segment in series.

## Patentansprüche

1. Spannungssensoreinrichtung mit einem Hochspannungsteil (1) und einem Niederspannungsteil (2), wobei die Spannungssensoreinrichtung umfasst:
- mehrere Segmente (10); und
- mehrere Impedanzelemente (20);
wobei der Hochspannungsteil aus mindestens einem Segment gebildet wird und der Niederspannungsteil aus mindestens einem Segment gebildet wird;
wobei jedes Segment mindestens ein Impedanzelement, einen isolierten Träger (30) und ein Verbindungssystem (40) umfasst;
wobei das Verbindungssystem für jedes Segment einen ersten Teil an einem ersten Ende jedes Segments und einen zweiten Teil an einem zweiten Ende jedes Segments aufweist;
wobei das Verbindungssystem ausgelegt ist zum mechanischem Verbinden benachbarter Paare von Segmenten miteinander und das Verbindungssystem ausgelegt ist zum elektrischen Verbinden des mindestens einen Impedanzelements von benachbarten Paaren von Segmenten miteinander, wobei ein erster Teil des Verbindungssystems eines Segments von benachbarten Paaren von Segmenten ausgelegt ist zum Verbinden mit einem zweiten Teil des Verbindungssystems eines zweiten Segments von benachbarten Paaren von Segmenten;
wobei das Verbindungssystem ausgelegt ist, um zu ermöglichen, dass der Winkel zwischen benachbarten Paaren von Segmenten verändert wird;
**dadurch gekennzeichnet, dass**
die Impedanzelemente entweder kapazitive Elemente oder eine Kombination aus resistiven Elementen und kapazitiven Elementen sind; und
die Impedanzelemente innerhalb mindestens eines Segments parallel geschaltet sind und die Impedanzelemente innerhalb mindestens eines anderen Segments in Reihe geschaltet sind.

## Revendications

1. Dispositif de détection de tension, doté d'une partie (1) à haute tension et d'une partie (2) à basse tension, le dispositif de détection de tension comportant :
- une pluralité de segments (10) ; et
- une pluralité d'éléments (20) d'impédance ;
la partie à haute tension étant formée d'au moins un segment et la partie à basse tension étant formée d'au moins un segment ;
chaque segment comportant au moins un élément d'impédance, un support isolé (30) et un système (40) de connexion ;
le système de connexion pour chaque segment comprenant une première partie à une première extrémité de chaque segment et une seconde partie à une seconde extrémité de chaque segment ;
le système de connexion étant configuré pour relier mécaniquement des paires adjacentes de segments l'une à l'autre et le système de connexion étant configuré pour relier électriquement l'élément ou les éléments d'impédance de paires adjacentes de segments l'un à l'autre, une première partie du système de connexion d'un segment de paires adjacentes de segments étant configuré pour se connecter à une seconde partie du système de connexion d'un second segment de paires adjacentes de segments ;
le système de connexion étant configuré pour permettre à l'angle entre des paires adjacentes de segments d'être modifié ;
**caractérisé en ce que** les éléments d'impédance sont soit des éléments capacitifs, soit une combinaison d'éléments résistifs et d'éléments capacitifs ; et **en ce que**
les éléments d'impédance sont connectés au sein d'au moins un segment en parallèle et les éléments d'impédance sont connectés au sein d'au moins un autre segment en série.
